# EUROPÄISCHE PATENTANMELDUNG

(11) **EP 0 684 639 A1**
(43) Veröffentlichungstag der Anmeldung: **29.11.1995**
(21) Anmeldenummer: 95106710.7
(22) Anmeldetag: 04.05.1995
(51) Int. Cl.: H01L 21/331, H01L 29/737

(54) **Verfahren zur Herstellung eines Bipolartransistors**

(30) Priorität: 24.05.1994 DE 4417916
(71) Anmelder: Daimler-Benz Aktiengesellschaft, D-70546 Stuttgart (DE); TEMIC TELEFUNKEN microelectronic GmbH, D-74072 Heilbronn (DE)
(72) Erfinder: König, Ulf, Dr., D-89075 Ulm (DE); Gruhle, Anreas, Dr., D-89981 Ulm (DE); Schüppen, Andreas, Dr., D-89075 Ulm (DE); Kibbel, Horst, D-89155 Erbach (DE); Dietrich, Harry, D-74912 Kirchhardt (DE); Hefner, Hainz-Achim, D-74336 Brackenheim (DE)
(74) Vertreter: Weber, Gerhard, Dipl.-Phys.

(57) **Zusammenfassung**

Es wird ein Verfahren zur Herstellung eines Bipolartransistors für höchste Frequenzen angegeben, welches insbesondere für die Herstellung von Hetero-Bipolartransistoren von Vorteil ist und Bauelemente mit geringen parasitären Kapazitäten und geringem Basiszuleitungswiderstand ergibt.

## Beschreibung

Die Erfindung betrifft ein Verfahren zur Herstellung eines Bipolartransistors.

Der Einsatz von Transistoren im Bereich der höchstintegrierten oder multifunktionalen Schaltungen erfordert eine Reduktion der Dimensionen der Bauelemente und eine Steigerung der Geschwindigkeit der Bauelementfunktion. Neben den gebräuchlichen Bipolartransistoren (BJT) gilt das Interesse zunehmend auch den Heterobipolartransistoren (HBT).

Ein Bipolartransistor kann bis zu einer maximalen Frequenz fmax betrieben werden, bei der seine Leistungsverstärkung auf 1 abgefallen ist.

Die Frequenz fmax ist umgekehrt proportional zur Wurzel aus dem Produkt aus der Kapazität C_{B}α zwischen Basis B und Kollektor C und dem Basiswiderstand R_{B}. Die Kollektor-Basiskapazität wird bestimmt durch die Größe der Emitterfläche und parasitäre Kapazitäten, die unvermeidlich durch die Basiskontakte hervorgerufen werden. Der Widerstand R_{B} wird im wesentlichen durch die Dotierung und Dicke der Basis, der Leitfähigkeit der metallischen Zuleitung und den Kontaktwiderstanden bestimmt.

Zur Verringerung parasitärer Kollektor-Kapazitäten ist es aus EP 0 355 799 A2 und US-4 663 831 bekannt, die aktiven Transistorbereiche mit gleichen lateralen Abmessungen zu wachsen, indem in eine Schichtenfolge aus polykristallinem Halbleitermaterial und/oder Isolationsmaterial ein vertikaler Graben geätzt und die Transistorschichtenfolge in den Graben abgeschieden wird. Die Zuleitungen zu tieferliegenden Transistorschichten erfolgen durch separate horizontale Zonen.

Aus EP 0 189 136 ist es bekannt, zur Verringerung des Basiszuleitungswiderstands einer in einen Graben abgeschiedenen Transistorschichtenfolge eine den Basisbereich umgebende hochdotierte polykristalline Zone als Diffusionsquelle zur Herstellung hochdotierter Basiskontaktbereiche vorzusehen und die Basiszuleitung durch diese Basiskontaktbereiche, die polykristalline Zone und eine Silizid-Schicht zu bilden.

Aufgabe der vorliegenden Erfindung ist es, ein Verfahren zur Herstellung eines Bipolartransistors, insbesondere eines Heterobipolartransistors anzugeben, mit welchen auf einfache Weise Bauelemente mit vorteilhaften Höchstfrequenzeigenschaften herstellbar sind.

Die Erfindung ist im Patentanspruch 1 beschrieben. Die Unteransprüche enthalten vorteilhafte Ausgestaltungen und Weiterbildungen der Erfindung.

Durch die Vorstrukturierung der ersten Schicht mit Isolatinosgebieten entsteht als Basis für das differentiell epitaktische Wachstum eine im wesentliche ebene Oberfläche, so daß bei der nachfolgenden differentiellen Epitaxie eine Transistorstruktur entsteht, bei welcher einerseits in vertikaler Richtung automatisch die polykristalline Zuleitungsschicht auf Höhe der monokristallinen Basisschicht zu liegen kommt und anderseits die monokristallinen Transistorschichten selbstjustierend mit gleichen lateralen Abmessungen übereinander entstehen. Durch die gleichen lateralen Abmessungen der Transistorzonen und durch die Isolationsgebiete unterhalb der Basiszuleitung werden parasitäre Kapazitäten minimiert. Die Erfindung ist besonders vorteilhaft für die Herstellung eines Hetero-Bipolartransistors, bei welchem durch die hohe Dotierung der Basisschicht gleichzeitig eine hoch dotierte und damit widerstandsarme polykristalline Zuleitungsschicht entsteht und bei welchem die der gering dotierten Emitterschicht entsprechende polykristalline Schicht durch Leitfähigkeitsänderung zusätzlich als Basiszuleitung benutzt werden kann.

Die Erfindung ist nachfolgend anhand von Ausführungsbeispielen unter Bezugnahme auf die Abbildungen noch eingehend veranschaulicht. Als bevorzugtes Beispiel ist die Herstellung eines npn-Hetero-Bipolartransistors auf einem Silizium-Substrat gewählt.

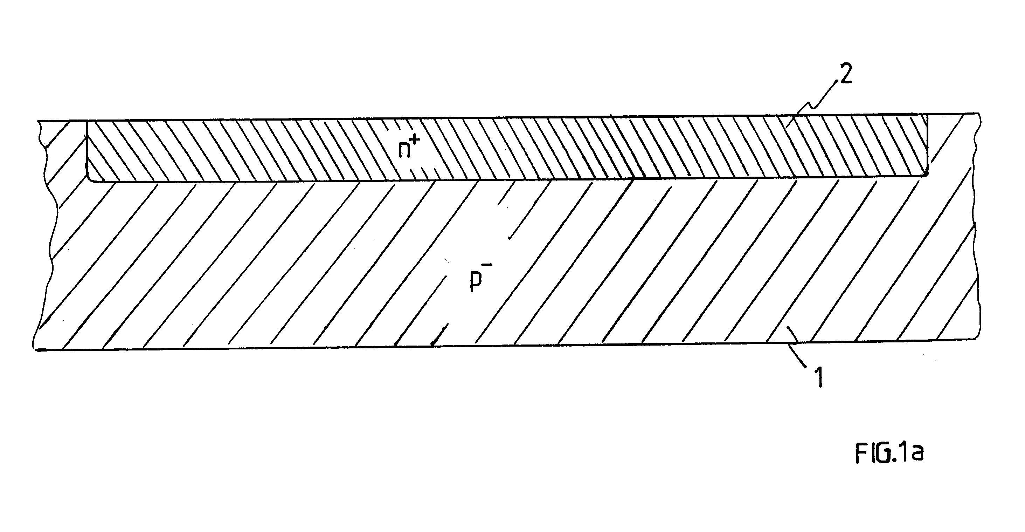

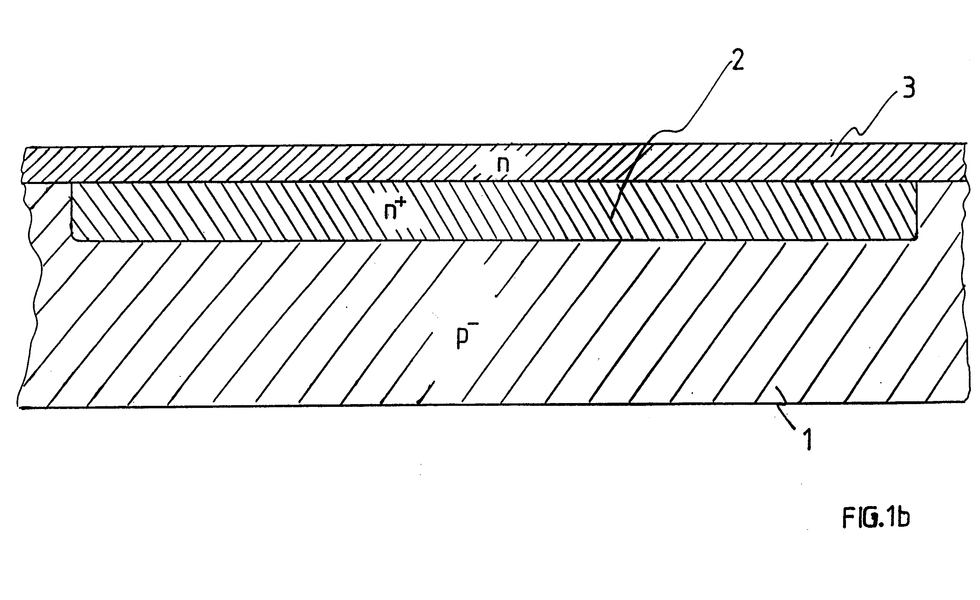

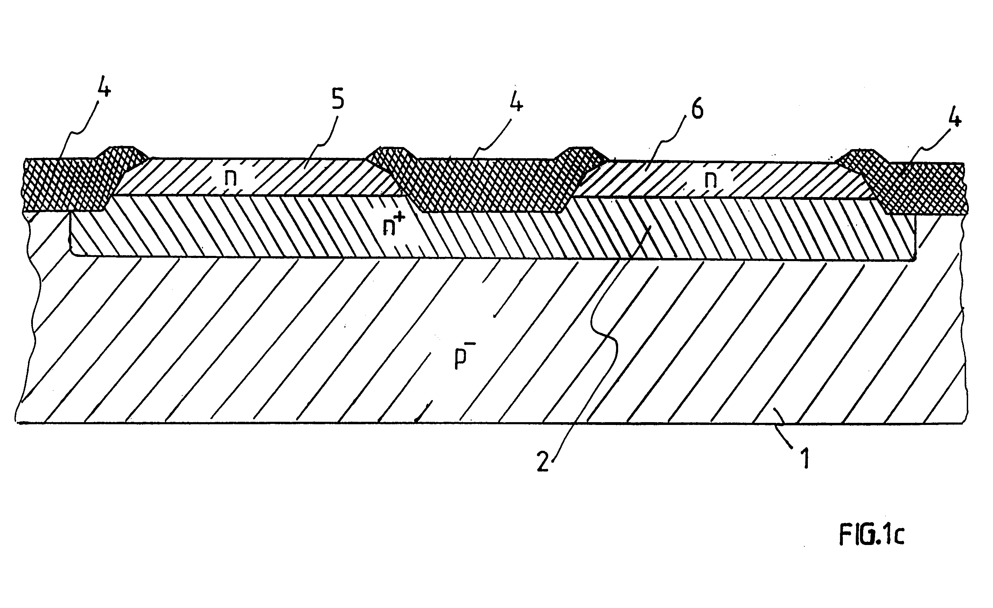

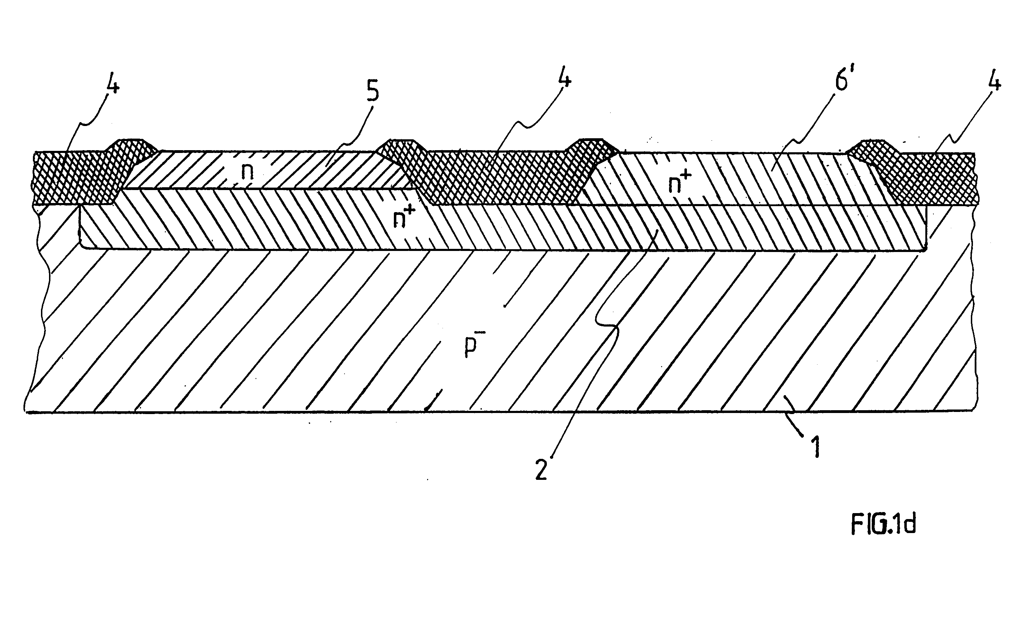

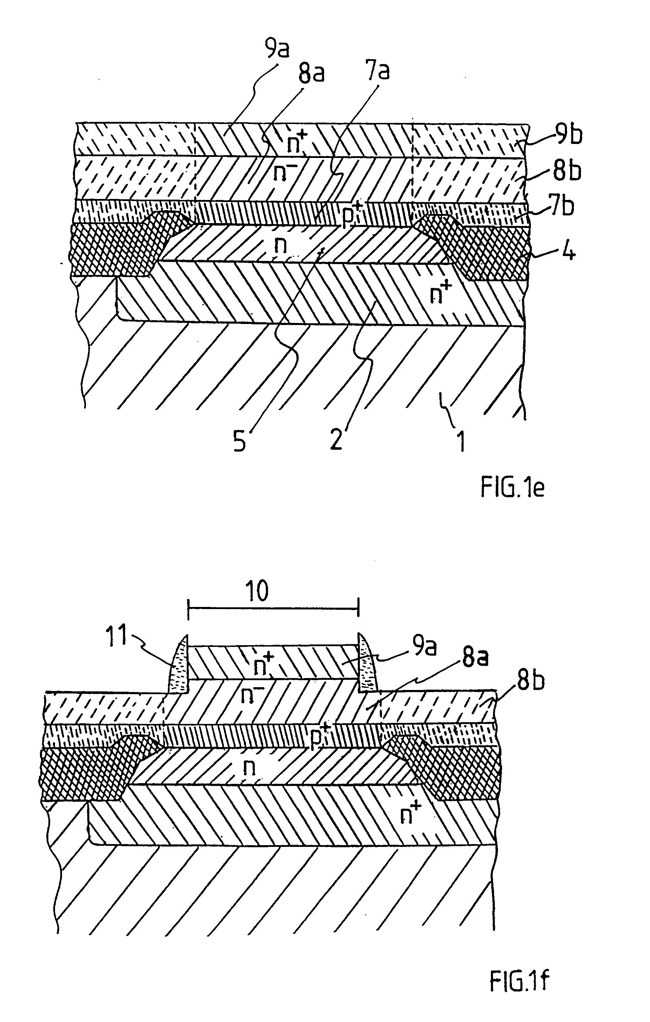

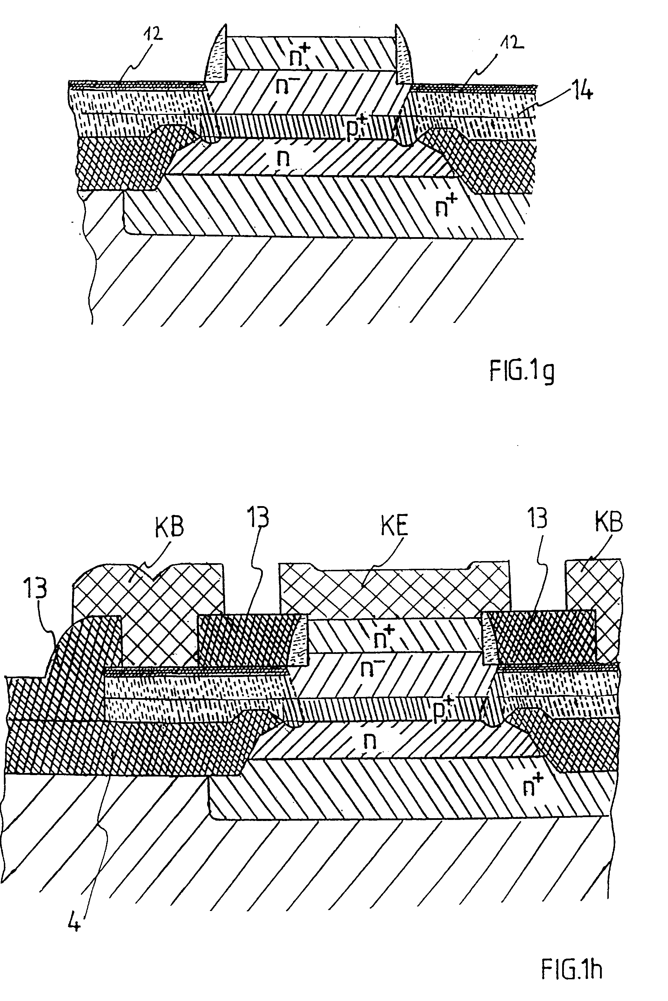

In gebräuchlicher Weise wird in einem gering p--dotierten Substrat 1 eine hoch n⁺⁻dotierte Wanne 2, z.B. durch Implantation mit anschließender Diffusion erzeugt (FIG. 1 a). Diese Wanne 2 dient im fertigen Transistor als vergrabene niederohmige Kollektorzuleitungsschicht. Auf das Substrat 1 mit Wanne 2 wird eine Kollektorschicht 3 aufgewachsen, deren n-Dotierung entsprechend der vorgesehenen Dotierung der Kollektorzone des Transistors gewählt wird (FIG. 1 b). In dieser Schicht werden z.B. durch photolithographische Strukturierung und lokale Oxidation des Halbleitermaterials (LOCOS oder recessed LOCOS) Isolationsgebiete 4 erzeugt, die vorzugsweise bis in das Substrat 1 bzw. die Wanne 2 reichen und die in der Kollektorschicht 3 eine Kollektorzone 5 und eine Kollektoranschlußzone 6 definieren (FIG. 1 c). Der Isolationsschritt ermöglicht die Herstellung mehrerer Bauelementstrukturen und die Separartion von Bauelementen gleichzeitig.

Anstelle der Erzeugung von Isolationsgebieten 4 im Halbleitermaterial der Kollektorschicht 3 kann eine Separation durch das strukturierte Ätzen von Gräben und deren Auffüllen mit isolierendem Material oder ein anderes bekanntes Separationsverfahren treten.

Auf an sich bekannte Weise kann z.B. mittels einer lokalen Implantation in der Kollektoranschlußzone 6 ein höherdotierter und in die Wanne 2 reichender Kollektoranschluß 6' hergestellt werden (FIG. 1 d).

Auf die abgesehen von ggf. geringen Aufwölbungen an den Rändern der Isolationsgebiete ebene Oberfläche der strukturierten Kollektorschicht 3 (FIG. 1c) wird anschließend mittels differentieller Epitaxie eine Schichtenfolge abgeschieden, welche über der Kollektorzone 5 monokristallin als hoch p⁺⁻dotierte Basisschicht 7a, gering n--dotierte Emitterschicht 8a und hoch dotierte Emitteranschlußschicht 9a und gleichzeitig über den Isolationsgebieten als polykristalline Schichtenfolge 7b, 8b, 9b entsprechender Dotierung aufwächst (FIG. 1 e).

Für die Herstellung eines Hetero-Bipolartransistors auf einem Si-Substrat besteht die Basisschicht 7a vorzugsweise aus verspanntem SiGe.

Um eine aktive Emitterzone 10 aus dem monokristallinen Bereich wird mittels an sich bekannter Verfahren das abgeschiedene Material bis unter die Schichtgrenze des hochdotierten Emitteranschlußschicht 9a zur gering dotierten Emitterschicht 8a freigeätzt, wobei vorzugsweise die Fläche der aktiven Emitterzone 10 annähernd gleich der Flächenausdehnung der einkristallin gewachsenen Schichtenfolge ist (FIG. 1f).

Der verbleibende Teil der gering n- dotierten polykristallinen Schicht 8b kann vorteilhafterweise nach Leitfähigkeitsänderung neben der hochdotierten polykristallinen Schicht 7b als Basiszuleitung mit genutzt werden, wodurch der Basiszuleitungswiderstand verringert werden kann. Vorzugsweise wird in an sich, z.B. aus der EP 0 355 799 A2, bekannter Weise vor der Änderung der Leitfähigkeit der polykristallinen n--Schicht 8b um die freigelegte aktive Emitterzone 10 ein Ring 11 aus abschirmendem Material, ein sogenannter spacer erzeugt (FIG. 1f).

Für die Änderung der Leitfähigkeit der polykristallinen Schicht 8b sind insbesondere die Umdotierung in einen anderen Leitfähigkeitstyp durch Implantation und die teilweise Umwandlung in ein Silizid von Vorteil, die einzeln oder kombiniert eingesetzt werden können. Bei der Umdotierung von n- nach p⁺ durch Implantion wird vorzugsweise die polykristalline Schicht 7b zusätzlich nachdotiert. Vorteilhafterweise liegt die Grenze zwischen polykristallinem Material der Schicht 7b und monokristallinem Material der Schicht 7a im Bereich der Implantation und wird von dieser mit umfaßt, so daß der Poly-Mono-Übergang elektrisch nicht zu Störungen führen kann. Die Implantation kann auch zu einer geringen Verschiebung der p-n-Dotierung zwischen Basis und Kollektor führen, was aber die Transistorfunktionen nicht beeinträchtigt. Es entsteht eine elektrisch einheitliche hoch p⁺⁻dotierte Zuleitungsschicht 14, die im oberen Bereich zusätzlich in ein Silizid 12 umgewandelt wird (FIG. 1 g). Im Bereich des Emitters, d.h. auf der Schicht 9a, kann gleichfalls ein Silizid erzeugt werden.

Auf diese Anordnung wird eine weitere Isolationsschicht 13, vorzugsweise Si0₂ abgeschieden, in welcher Fenster geöffnet und metallische Anschlußkontakte KB für die Basiszuleitung und KE für den Emitteranschluß hergestellt werden.

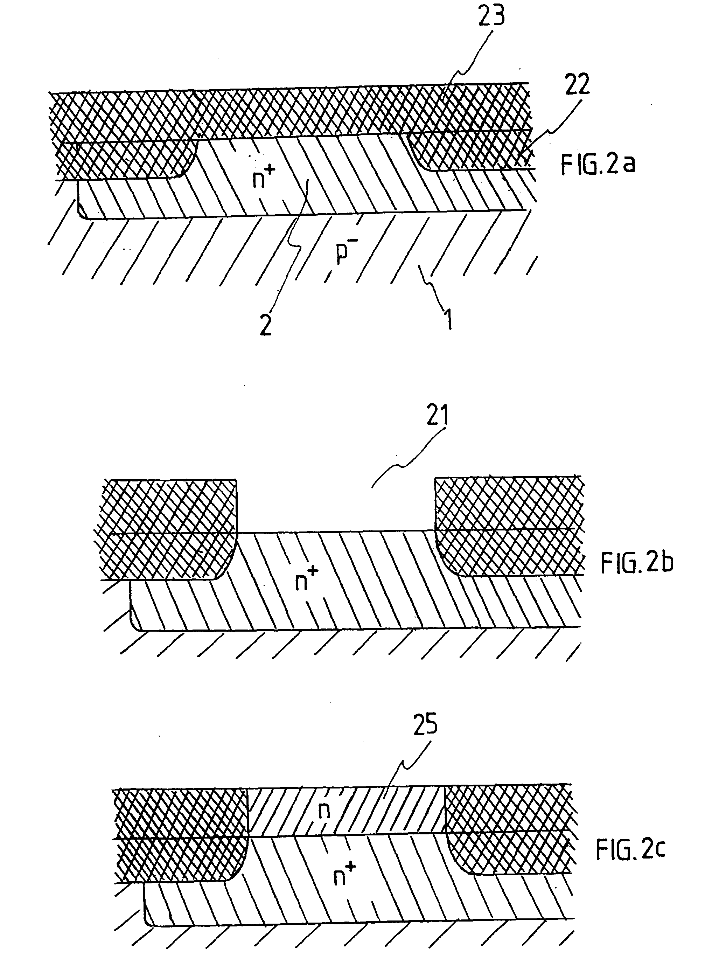

Anstelle der Strukturierung der ersten Schicht durch Einbringen von Isolationsgebieten in eine Halbleiterschicht sieht eine alternative Ausführungsform vor, auf das Substrat 1 mit Wanne 2 eine Isolationsschicht 23, vorzugsweise Si0₂ aufzubringen, deren Dicke gleich der für die Kollektorzone vorgesehenen Dicke gewählt wird (FIG. 2a). In dieser Isolationsschicht wird ein Fenster 21 bis zur monokristallinen Halbleiteroberfläche freigelegt (FIG. 2b). Wenn zur besseren Isolation und/oder zur weiteren Reduzierung parasitärer Kapazitäten eine dickere Isolationsschicht gewünscht wird, können unter Zugrundelegung einer entsprechend tieferen Wanne 2 zuerst Isolationsschichten 22 in Substrat 1 und Wanne 2, z.B. nach einem der in Zusammenhang mit dem ersten Ausführungsbeispiel erwähnten bekannten Verfahren (LOCOS, Grabenisolation) hergestellt und die Isolationsschicht 23 darauf abgeschieden werden.

In das Fenster 21 wird n-dotiertes Halbleitermaterial monokristallin als Kollektorzone 25 abgeschieden. Vorzugsweise erfolgt die Abscheidung selektiv, d.h. ohne gleichzeitige Abscheidung von Material auf der Oxidschicht. Dies ist für gebräuchliche Gasphasenepitaxieverfahren durch geeignete Einstellung der Gaszusammensetzung bekannt. Die Wachstumszeit wird so gewählt, daß die Oberfläche der Kollektorzone möglichst planar mit der Oberfläche der Isolationsschicht 23 abschließt (FIG. 2c). Daran schließt sich der differentielle Epitaxieschritt wie zu FIG. 1 und folgende beschrieben an. Besonders vorteilhaft ist es, das selektive Wachstum der Kollektorzone und das anschließende differentielle Wachstum in einem Epitaxieprozeß durchzuführen, bei welchem lediglich für den Übergang von der selektiven Abscheidung nach Erreichen der erforderlichen Dicke der Kollektorzone die Parameter der Epitaxie auf differentielle Abscheidung umgestellt werden.

Die Erfindung ist nicht auf die im Detail beschriebene bevorzugte Herstellung eines npn-Hetero-Bipolartransistor beschränkt sondern auf komplentäre Dotierung und auf gewöhnliche Bipolartransistoren in analoger Weise anwendbar. Das Materialsystem ist nicht auf Si und SiGe beschränkt. Insbesondere können auch III-V-Halbleitermaterialien zum Einsatz kommen. Es bietet sich auch die Möglichkeit einer "Collector-on-top"-Anordnung, bei welcher die Reihenfolge der Transistorschichten umgekehrt ist. Die bei der lokalen Oxidation an den Rändern der Isolationsgebiete entstehenden Aufwölbungen können mit Standardverfahren planarisiert werden, bevor die differentielle Epitaxie begonnen wird.

Typische Werte eines nach der Erfindung hergestellten SiGe-HBT sind für
- die Herstellung der Isolationsgebeite mit recessed LOCOS eine Tiefe von l um
- die Kollektorzone 5 eine Dotierung von 5x10¹⁶cm⁻³ und eine Schichtdicke von 0,1-0,5 um
- die Basiszone 7a und die entsprechende polykristalline Schicht 7b eine 20-60 nm dicke Siₒ,ₛGeₒ,₂-Schicht mit einer Dotierung von 5x10¹⁹ cm⁻³
- die Emitterzone 8a eine 40-200 nm dicke Si-Schicht mit einer Dotierung von 1x10¹⁸cm⁻³
- den Emitterkontakt 9a eine 20-300 nm dicke Si-Schicht mit einer Dotierung von 2x1020CM-3
- die Breite der Si0₂-spacer 11 100-200 nm
- die weitere Isolationsschicht 13 eine Dicke von 1 um
- die Metallisierung der Kontakte KB, KE und des nicht gezeigten Kollektorkontakts eine

TiAu-Schicht mit einer Dicke von 1 um ohne daß die Erfindung auf diese bevorzugten Wertebereiche eingeschränkt sein soll.

## Patentansprüche

1. Verfahren zur Herstellung eines Bipolartransistors mit folgenden Merkmalen:
- auf einer monokristallinen Zuleitungsschicht wird eine strukturierte erste Schicht mit einer Kollektorzone und mit diese umgebenden Isolationsgebieten erzeugt
- auf der ersten Schicht wird in differentieller Epitaxie über der Kollektorzone eine mono-kristalline Transistor-Schichtenfolge und gleichzeitig über den Isolationsgebieten eine polykristalline Schichtenfolge aufgewachsen
- die polykristalline Schichtenfolge wird als Basiszuleitung ausgebildet.

2. Verfahren nach Anspruch 1, dadurch gekennzeichnet, daß für die strukturierte erste Schicht in einer Kollektorschicht selektiv Isolationsgebiete erzeugt werden.

3. Verfahren nach Anspruch 2, dadurch gekennzeichnet, daß die Isolationsgebiete durch lokale Oxidation des Halbleitermaterials der Kollektorschicht erzeugt werden kann.

4. Verfahren nach Anspruch 2, dadurch gekennzeichnet, daß die Isolationsgebiete durch Grabenätzung und Abscheiden von Isolationsmaterial in den Gräben erzeugt werden.

5. Verfahren nach Anspruch 1, dadurch gekennzeichnet, daß für die strukturierte erste Schicht in einer Isolationsschicht ein Fenster bis zur Zuleitungsschicht freigelegt wird und daß in dem Fenster selektiv epitaktisch monokristallines Halbleitermaterial für die Kollektorzone abgeschieden wird.

6. Verfahren nach Anspruch 5, dadurch gekennzeichnet, daß nach dem Abscheiden der Kollektorzone im selben Epitaxieprozeß durch Verändern der Prozeßparameter der differentielle Epitaxieschritt ausgeführt wird.

7. Verfahren nach einem der Ansprüche 1 bis 6, dadurch gekennzeichnet, daß innerhalb der monokristallinen Schichtenfolge eine aktive Emitterzone freigelegt wird.

8. Verfahren nach einem der Ansprüche 1 bis 7, dadurch gekennzeichnet, daß die monokristalline Schichtenfolge als Schichtenfolge eines Heterobipolartransistors mit einer gering dotierten Emitterschicht gewachsen wird, und daß die der gering dotierten Emitterschicht entsprechende polykristalline Schicht als Teil der Basiszuleitung verwendet wird.

9. Verfahren nach Anspruch 8, dadurch gekennzeichnet, daß die der gering dotierten Emitterschicht entsprechende polykristalline Schicht in den Leitfähigkeitstyp der Basisschicht umdotiert wird.

10. Verfahren nach Anspruch 9, dadurch gekennzeichnet, daß die Umdotierung durch lonenimplantation vorgenommen wird.

11. Verfahren nach einem der Ansprüche 1 bis 10, dadurch gekennzeichnet, daß die polykristalline Basiszuleitungsschicht teilweise in ein Silizid umgewandelt wird.

12. Verfahren nach einem der Ansprüche 9 bis 11, dadurch gekennzeichnet, daß die Grenzen zwischen polykristallinem und monokristallinem Material bei der Umdotierung und/oder Silizidumwandlung mit eingeschlossen werden.

13. Verfahren nach einem der Ansprüche 7 bis 12, dadurch gekennzeichnet, daß entlang der freiliegenden lateralen Grenzflächen der aktiven Emitterzone ein Ring aus die Umdotierung und/oder Silizidumwandlung abschirmendem Material hergestellt wird.

14. Verfahren nach einem der Ansprüche 8 bis 13, dadurch gekennzeichnet, daß für die Basisschicht verspanntes SiGe aufgewachsen wird.
